# EUROPEAN PATENT APPLICATION

(11) **EP 1 422 760 A2**
(43) Date of publication of application: **26.05.2004**
(21) Application number: 03090388.4
(22) Date of filing: 17.11.2003
(51) Int. Cl.: H01L 29/786, H01L 21/336

(54) **Thin film transistors and organic electroluminescent device using the same**

(30) Priority: 19.11.2002 KR 2002071998
(71) Applicant: Samsung SDI Co., Ltd., Suwon-city, Gyeonggi-do (KR)
(72) Inventor: Park, Ji Yong, Suwon-city Gyeonggi-do (KR); Park, Hye Hyang, Gwonseon-gu Suwon-city (KR)
(74) Representative: Hengelhaupt, Jürgen D., Dipl.-Ing.

(57) **Abstract**

A thin film transistor having superior uniformity and an organic electroluminescent device using the same, and provides a thin film transistor which is characterized in that primary crystal grain boundaries of polycrystalline silicon do not meet boundaries between drain regions and active channel regions, thereby providing a thin film transistor having superior uniformity due to superior electric current characteristics so that the thin film transistor can be used in an organic electroluminescent device with superior performance.

## Description

### CROSS-REFERENCE TO RELATED APPLICATIONS

This application claims the benefit of Korean Application No. 2002-19723, filed April 11, 2002, in the Korean Intellectual Property Office, the disclosure of which is incorporated herein by reference.

### BACKGROUND OF THE INVENTION

### 1. Field of the Invention

The present invention relates to a thin film transistor having superior uniformity and charge characteristics and an organic electroluminescent device using the same, and more particularly, to a thin film transistor having superior uniformity in which polycrystalline silicon is manufactured by using SLS crystallization technology, and the polycrystalline silicon is used, and an organic electroluminescent device using the thin film transistor.

### 2. Description of the Related Art

Bonding defects such as atom dangling bonds existing on crystal grain boundaries of polycrystalline silicon included in an active channel region are known to act as a trap on electric charge carriers when fabricating a TFT (thin film transistor) using polycrystalline silicon.

Therefore, size uniformity, number and position, and direction of the crystal grains not only directly or indirectly exert a fatal influence on TFT characteristics such as threshold voltage (Vth), subthreshold slope, charge carrier mobility, leakage current and device stability, but also exert a fatal influence on uniformity of TFTs depending on position of the crystal grains when fabricating an active matrix display substrate using TFTs.

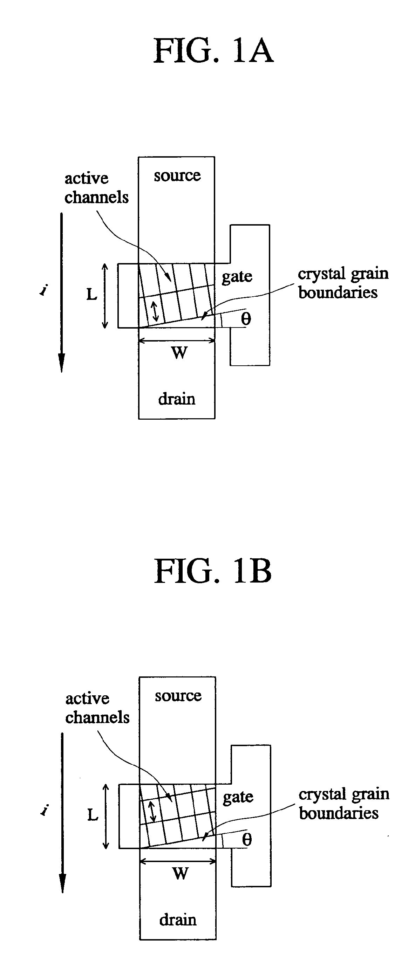

The number of fatal crystal grain boundaries (hereinafter referred to as "primary" crystal grain boundaries) included in active channel regions of TFTs on the whole substrate of a display device can be equal or different with respect to each other depending on the dimension (length (L), width (W)) of an active channel and the position of each TFT on the substrate (FIG. 1A and FIG. 1B).

A "primary" crystal grain boundary has an inclined angle from 45° to 135° of the crystal grain boundary with respect to a current flow direction and can be controlled in a position in a polycrystalline silicone formed on the substrate.

As in FIG. 1A and FIG. 1B, the number of the "primary" crystal grain boundaries included in the active channel region for the size of crystal grains being Gs, the dimension of an active channel being L X W and inclination angle of the crystal grain boundary being e , depending on the position of a TFT substrate or a display device, is Nmax (three in case of FIG. 1A) or Nmax-1 (two in case of FIG. 1B), where the number of the maximum crystal grain boundaries is Nmax, and the superior uniformity of TFT characteristics can be obtained when the number of the "primary" crystal grain boundaries of Nmax for all TFTs is included in the active channel region. Namely, the more equal number of crystal grain boundaries each of the TFTs has, the more superior uniformity the device has.

On the other hand, it is easily expected that the uniformity in TFT characteristics on the TFT substrate or the display device is the worst condition if the number of TFTs including Nmax "primary" crystal grain boundaries is equal to the number of TFTs including Nmax-1 "primary" crystal grain boundaries.

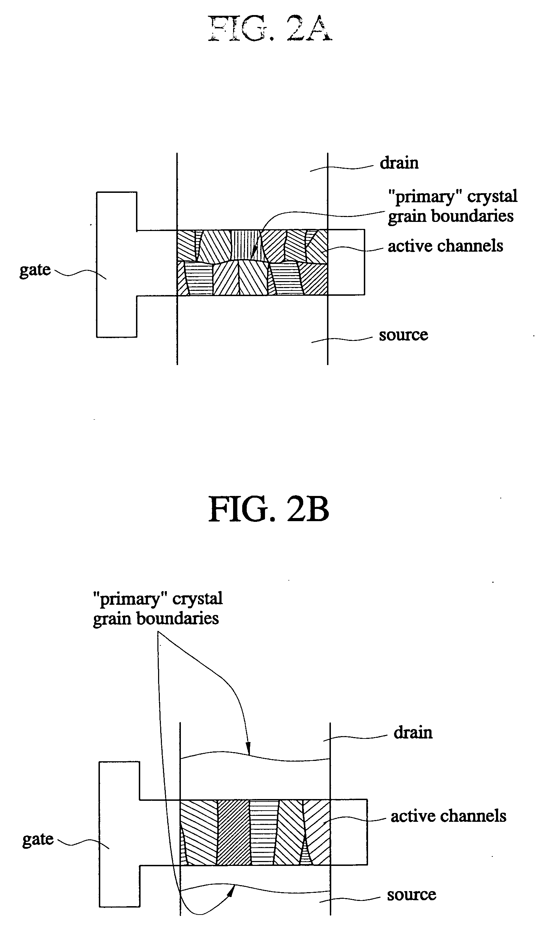

It is known that polycrystalline or single crystalline particles are capable of forming large silicon grains on a substrate using SLS (sequential lateral solidification) crystallization technology, as shown in FIG. 2A and FIG. 2B, and characteristics similar to characteristics of a TFT fabricated with single crystalline silicon can be obtained when fabricating a TFT using the large silicon grains.

However, a great number of TFTs for a driver and a pixel array should be fabricated in order to fabricate an active matrix display.

For example, approximately one million pixels are made during the fabrication of an active matrix display having an SVGA class resolution, one TFT is required in each pixel in the case of a liquid crystal display, and at least two or more TFTs are required in a display using an organic light emitting substance, for example, an organic electroluminescent device.

Therefore, it is impossible to fabricate the crystal grains by growing a constant number of crystal grains in a certain direction only in one million or two million or more active channel regions of each TFT.

In order to supplement the problems, a technology is disclosed in PCT International Patent NO. WO 97/45827 that amorphous silicon is deposited by PECVD, LPCVD or a sputtering method to convert amorphous silicon on the whole substrate into polycrystalline silicon or crystallize only a selected region on the substrate by SLS as shown in FIG. 2A and FIG. 2B.

The selected region is also quite a wide region compared to an active channel region having a dimension of several µm X several µm. The size of a laser beam used in SLS crystalization is approximately several mm X dozens of mm, and stepping and shifting of the laser beam or stage are inevitably required to crystallize amorphous silicon of the whole substrate or a selected region on the substrate, wherein misalignment exists between regions on which a laser beam is irradiated so that the number of "primary" crystal grain boundaries included in active channel regions of numbers of TFTs varies, and the TFT on the whole substrate or in a driver region and pixel cell region will have unpredictable nonuniformity. The nonuniformity can have a fatally bad influence on the realization of an active matrix display device.

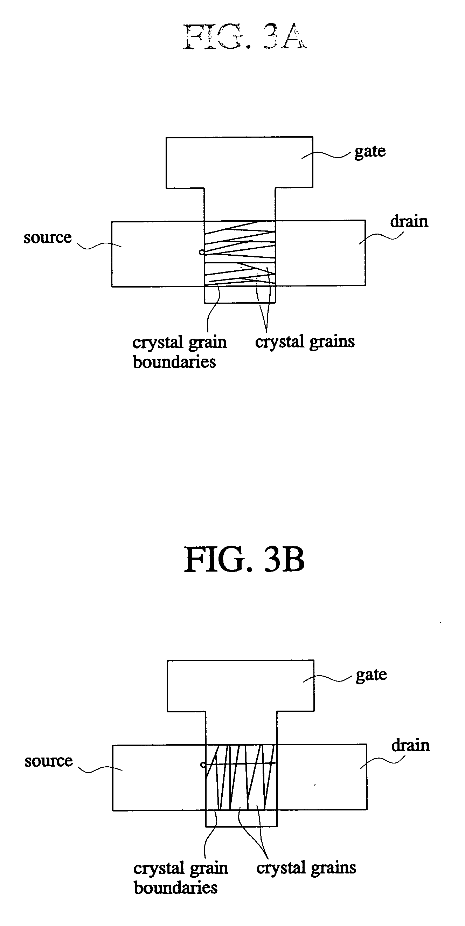

Furthermore, it is disclosed in U.S. Patent No. 6,177,301 that the barrier effect of the crystal grain boundaries for a direction of an electric charge carriers is minimized, as illustrated in FIG. 3A, in the case where a direction of the active channel is parallel to a direction of crystal grains grown by the SLS crystallization method when fabricating a TFT for LCD devices comprising a driver and pixel array by forming large silicon grains using SLS crystallization technology. Therefore, TFT characteristics of poly chrystalline silicon becomes as good as TFT characteristics of single crystalline silicon while TFT characteristics are greatly deteriorated, as illustrated in FIG. 3B, since many crystal grain boundaries in which TFT characteristics act as the trap of the electric charge carriers exist in the case where a direction of the active channel is perpendicular to a growing direction of the crystal grains.

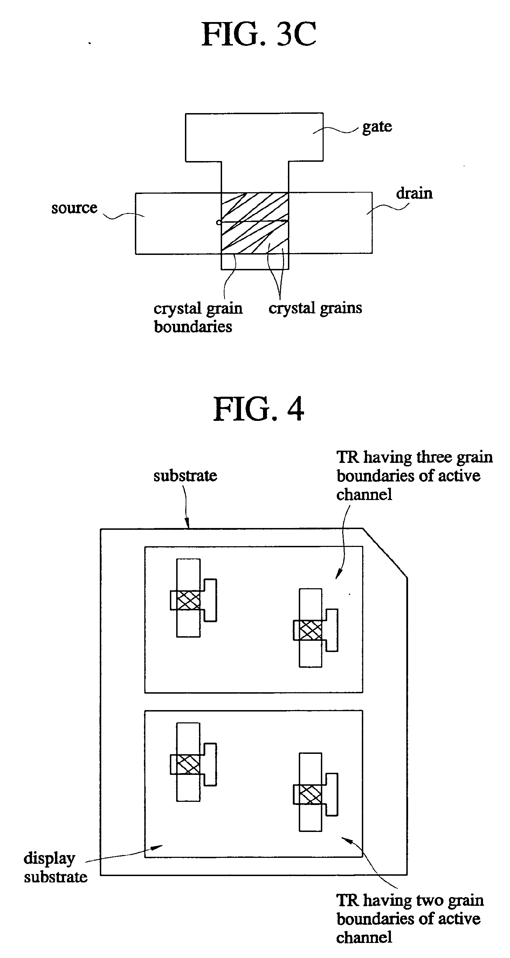

There are cases where a TFT in the driver circuit and a TFT in the pixel cell region usually have an angle of 90° when actually fabricating an active matrix display, wherein uniformity of the device can be improved by slantingly fabricating the active matrix display in such a way that a direction of the active channel region is inclined at a growing angle of the crystal grains of 30 to 60° so as to improve uniformity of characteristics between TFTs, while not greatly deteriorating the characteristics of each TFT, as illustrated in FIG. 3C.

However, there is a probability that fatal crystal grain boundaries are included in the active channel region as the methods above also use crystal grains having a limited size formed by the SLS crystallization technology. Therefore, the methods above have problems in that unpredictable nonuniformity causing differences in characteristics between TFTs exists.

### SUMMARY OF THE INVENTION

Accordingly, it is an aspect of the present invention to provide a TFT having superior uniformity and charge characteristics by using polycrystalline silicon formed by using SLS crystallization technology.

Additional aspects and advantages of the invention will be set forth in part in the description which follows and, in part, will be obvious from the description, or may be learned by practice of the invention.

The foregoing and/or other aspects of the present invention may be achieved by providing a thin film transistor which is characterized in that primary crystal grain boundaries of polycrystalline silicon do not meet boundaries between drain regions and active channel regions.

The foregoing and/or other aspects of the present invention may be achieved by providing an organic electroluminescent device including a fabricated thin film transistor which is characterized in that primary crystal grain boundaries of polycrystalline silicon do not meet boundaries between drain regions and active channel regions.

The foregoing and/or other aspects of the present invention may be achieved by providing a thin film transistor characterized in that primary crystal grain boundaries existing in polycrystalline silicon do not meet boundaries between drain regions and active channel regions of the thin film transistor and the existing primary crystal grain boundaries have an inclined angle from 45° to 135° with respect to a current flow direction.

The foregoing and/or other aspects of the present invention may be achieved by providing an organic electroluminescent device using the thin film transistor characterized in that primary crystal grain boundaries existing in polycrystalline silicon do not meet boundaries between drain regions and active channel regions of the thin film transistor and the existing primary crystal grain boundaries have an inclined angle from 45° to 135° with respect to a current flow direction.

The foregoing and/or other aspects of the present invention may be achieved by providing a thin film transistor characterized in that primary crystal grain boundaries existing in polycrystalline silicon are not within active channel regions of the thin film transistor and the existing primary crystal grain boundaries have an inclined angle from 45° to 135° with respect to a current flow direction.

In another aspect of the invention, the polycrystalline silicon of the above TFT is manufactured by an SLS method.

The foregoing and/or other aspects of the present invention may be achieved by providing an organic electroluminescent device using the thin film transistor characterized in that primary crystal grain boundaries existing in polycrystalline silicon are not within active channel regions of the thin film transistor and the existing primary crystal grain boundaries have an inclined angle from 45° to 135° with respect to a current flow direction.

The foregoing and/or other aspects of the present invention may be achieved by providing a thin film transistor comprising: primary crystal grain boundaries existing in polycrystalline silicon; and active channel regions, wherein the primary crystal grain boundaries are outside of the of the width of the active channel regions.

### BRIEF DESCRIPTION OF THE DRAWINGS

These and/or other aspects and advantages of the invention will become apparent and more readily appreciated from the following description of the preferred embodiments, taken in conjunction with the accompanying drawings of which:
FIG. 1A is a cross-sectional view schematically illustrating a TFT in which the number of fatal crystal grain boundaries is 2 for an equal crystal grain size Gs and an active channel dimension L X W;
FIG. 1B is a cross-sectional view schematically illustrating a TFT in which the number of fatal crystal grain boundaries is 3;
FIG. 2A and 2B are cross-sectional views schematically illustrating active channels of a TFT comprising silicon grains having a large particle size formed by a conventional sequential lateral solidification (SLS) crystallization method;
FIG. 3A to FIG. 3C are additional cross-sectional views schematically illustrating conventional fabricated active channels of a TFT;
FIG. 4 is a schematic drawing illustrating that the number of fatal crystal grain boundaries capable of having a fatal influence on characteristics of a TFT fabricated on a driving circuit substrate or a display can be varied depending on position of the TFT;
FIG. 5 is a photograph illustrating a cross section in which a polysilicon substrate is cut so that a width of primary crystal grain boundaries can be shown;
FIG. 6A is a cross-sectional view schematically illustrating a TFT fabricated according to an embodiment of the present invention;
FIG. 6B is a graph illustrating a relation of a source drain current and a gate voltage of the TFT of FIG. 6A;
FIG. 7 is a photograph illustrating that a hump is generated when primary grain boundaries are distanced far away from boundaries of drain regions and active channel regions;
FIG. 8A is a cross-sectional view schematically illustrating a TFT fabricated as a comparative example;
FIG. 8B is a graph showing a relationship between a source drain current and a gate voltage of the TFT of FIG. 8A; and
FIG. 9 is a photograph illustrating that a hump is generated when primary grain boundaries meet boundaries of drain regions and active channel regions.

### DESCRIPTION OF THE PREFERRED EMBODIMENTS

Reference will now made in detail to the preferred embodiments of the present invention, examples of which are illustrated in the accompanying drawings, wherein like reference numerals refer to the like elements throughout. The embodiments are described below in order to explain the present invention by referring to the figures.

A crystal grain boundary is formed between neighboring crystal grains due to a limited size of the crystal grains in the case where crystal grains of polycrystalline silicon directly and indirectly exerting an important influence on TFT characteristics when fabricating a TFT for an active matrix display are enlarged and regularized to improve the TFT characteristics.

"Size of crystal grains" in the present invention refers to a confirmable distance between crystal grain boundaries and is usually defined as a distance of the crystal grain boundaries that has fallen within the error range.

Particularly, a crystal grain boundary exerting a fatal influence on TFT characteristics when the crystal grain boundary exists in an active channel region, or when the primary crystal grain boundaries form an angle within the active channel region from 45° to 135° with respect to a current flow direction, results in inevitable defects due to the limit of processing accuracy when forming a polycrystalline silicon thin film.

Furthermore, the number of the "primary" crystal grain boundaries included in a TFT active channel region fabricated on a driving circuit substrate or a display substrate may be varied depending on the size and direction of the crystal grains, and the dimension of the active channels, as illustrated in FIG. 4. Therefore, characteristics of a TFT and a display fabricated become nonuniform, or worse, the TFT and/or the display containing these TFTs may not even be driven at all.

The present invention improves characteristics of TFT by taking into consideration that the position of "primary" crystal grain boundaries greatly influences TFT characteristics, and accordingly adjusts the position of the "primary" crystal grain boundaries to avoid these influences.

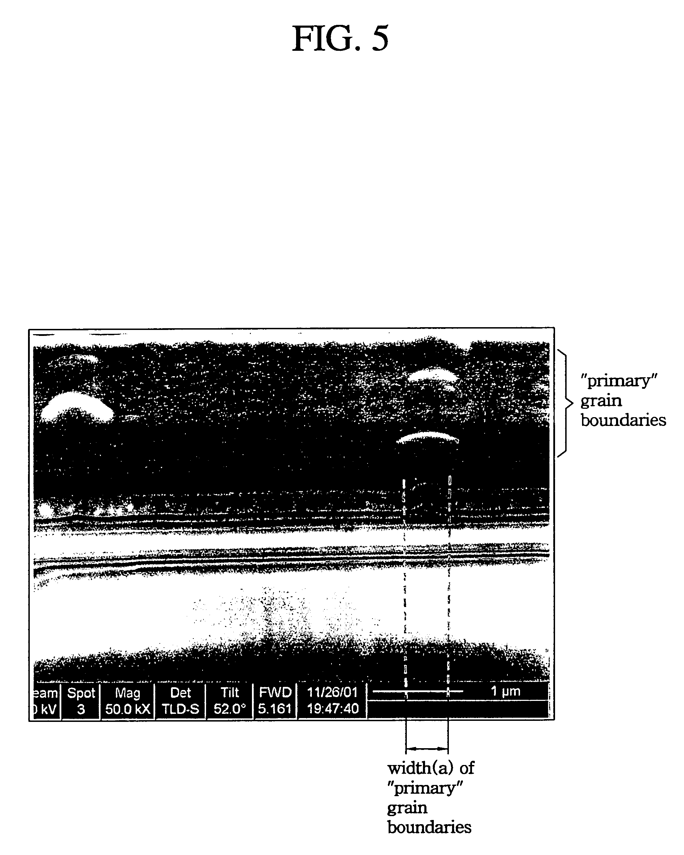

FIG. 5 is a photograph illustrating a cross section in which a polysilicon substrate is cut so that a width of the "primary" crystal grain boundaries can be shown, wherein the "primary" crystal grain boundaries usually have a length of about 1µm as a part (as in FIG. 5) between both end points where a bend of the polysilicon crystal surfaces begins to appear.

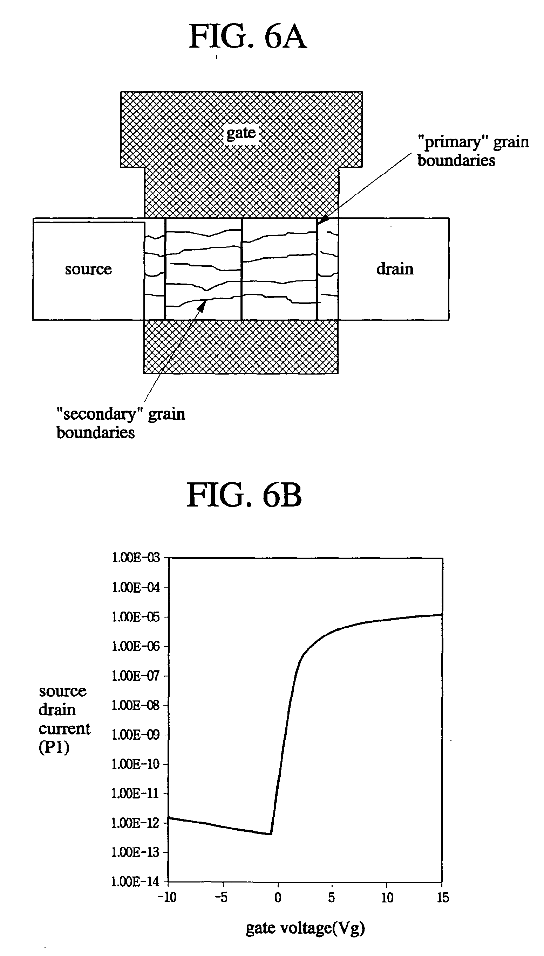

FIG. 6A is a cross-sectional view schematically illustrating a TFT fabricated according to an embodiment of the present invention, and FIG. 6B is a graph illustrating a relationship between a source drain current and a gate voltage of the TFT of FIG. 6A.

It can be seen by FIG. 6B that a curved line which is constant without variability of source drain current according to gate voltage, that is, a so-called "hump," is not generated when the "primary" crystal grain boundaries are spaced apart from a point of contact (tangent line) where an active channel region of the gate meets the drain by a certain distance, as illustrated in FIG. 6A.

The distance in which the "primary" crystal grain boundaries should be spaced apart from a point of contact (tangent line) where an active channel region of the gate meets the drain is a distance in which the width of the primary crystal grain boundaries is not overlapped with boundaries of active channel regions, as can be seen in FIG. 5.

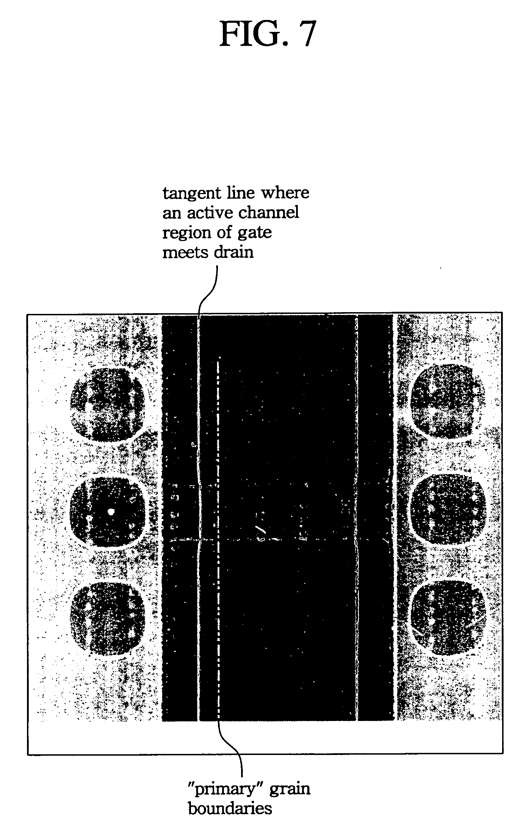

FIG. 7 illustrates a case where the hump is not generated, wherein it can be seen that the primary crystal grain boundaries are spaced apart from boundaries of active channel regions by a considerable distance.

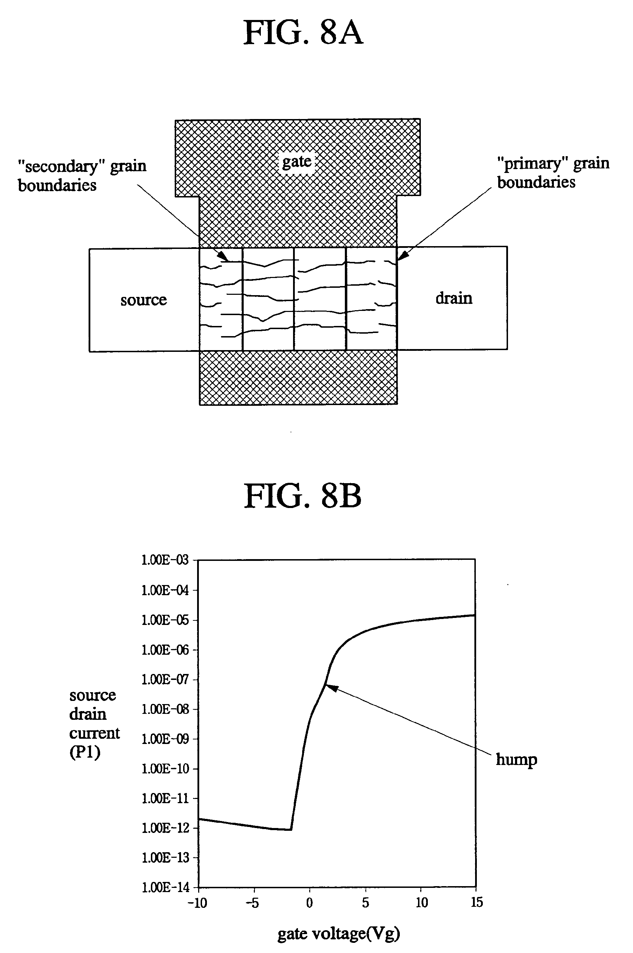

FIG. 8A is a cross-sectional view schematically illustrating a TFT fabricated as a comparative example, and FIG. 8B is a graph illustrating a relationship between a source drain current and a gate voltage of the TFT of FIG. 8A.

A "hump" in which variability of source drain current appears according to gate voltage, as can be seen in FIG. 8B, is generated in the case that a point of contact (tangent line) where an active channel region of the gate meets the drain is overlapped by a width of the "primary" crystal grain boundaries in FIG. 8A. Therefore, it is preferable that the "primary" crystal grain boundaries do not overlap with the point of contact (tangent line) where an active channel region of the gate meets the drain.

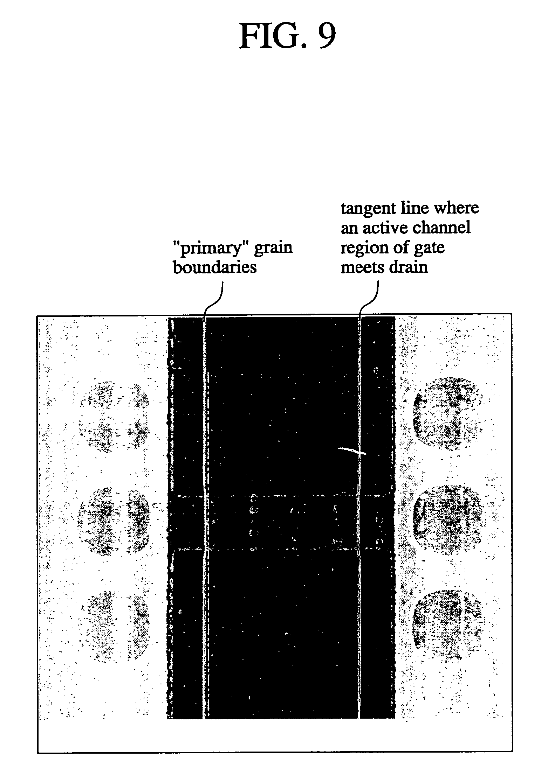

It can be seen that an example of a case where a "hump" is generated is where the boundaries of active channel regions are overlapped by the width of the "primary" crystal grain boundaries, as shown in a photograph of FIG. 9.

Therefore, a TFT having superior uniformity and charge characteristics can be provided where current characteristics are constantly maintained when a hump is not generated, as shown in FIG. 6A, while uniformity of the TFT is deteriorated where current characteristics are not constantly maintained when the hump is generated, as shown in FIG. 8A.

In the present invention, it is irrelevant that the "primary" crystal grain boundaries are perpendicular to a current flowing direction of source drain, or when the "primary" crystal grain boundaries form an angle from 45° to 135° with respect to the current flow direction.

Furthermore, in another embodiment of the present invention, the "primary" crystal grain boundaries do not exist in an active channel region of the gate, and therefore in this case, concern as to the number of the "primary" crystal grain boundaries that can exist in the active channel region is irrelevant.

Accordingly, good uniformity and charge characteristics of a TFT can be obtained since a phenomena such as the "hump" explained above is not generated even in the case where the size of the "primary" crystal grains is larger than the width of the active channel.

On the other hand, the polycrystalline silicon is formed by SLS (sequential lateral solidification) technology.

The fabricated thin film transistor can be used in a display device requiring the above conditions, and preferably can be used in an organic electroluminescent device since the thin film transistor has superior uniformity and charge characteristics with respect to current characteristics.

The present invention provides a TFT having superior characteristics by forming "primary" crystal grain boundaries as far as possible away from a region where the drain contacts an active channel region, thereby restraining generation of a hump to the utmost.

Although a few preferred embodiments of the present invention have been shown and described, it would be appreciated by those skilled in the art that changes may be made in this embodiment without departing from the principles and spirit of the invention, the scope of which is defined in the claims and their equivalents.

## Claims

1. A thin film transistor in which primary crystal grain boundaries existing in polycrystalline silicon do not meet boundaries between the drain region and the active channel region of the thin film transistor.

2. The thin film transistor of claim 1, wherein the width of the primary crystal grain boundaries is 1µm or less.

3. The thin film transistor of claim 1, wherein a center of the primary crystal grain boundaries is separated from the boundary between a drain region and an active channel region by at least 0.5 µm.

4. The thin film transistor of claim 1, wherein the size of primary crystal grains is greater than the width of the active channel regions.

5. The thin film transistor of claim 1, wherein the primary crystal grain boundaries and the current flow direction are perpendicular to each other.

6. The thin film transistor of claim 1, wherein an angle of the primary crystal grain boundaries to the direction of current flow is from 45° to 135° with respect to the current flow direction.

7. The thin film transistor of claim 1, wherein the polycrystalline silicon is manufactured by a sequential lateral solidification (SLS) method.

8. The thin film transistor of claim 1, wherein the primary crystalline grain boundaries do not exist within the active channel region.

9. An organic electroluminescent device using the thin film transistor of claim 1.

10. A thin film transistor in which primary crystal grain boundaries existing in polycrystalline silicon do not meet boundaries between a drain region and an active channel region of the thin film transistor and the existing primary crystal grain boundaries have an inclined angle from 45° to 135° with respect to a current flow direction.

11. The thin film transistor of claim 10, wherein the polycrystalline silicon is manufactured by a sequential lateral solidification (SLS) method.

12. An organic electroluminescent device using the thin film transistor of claim 10.

13. A thin film transistor in which the primary crystal grain boundaries existing in polycrystalline silicon are not within active channel regions of the thin film transistor.

14. The thin film transistor of claim 13, wherein the polycrystalline silicon is manufactured by a sequential lateral solidification (SLS) method.

15. An organic electroluminescent device using the thin film transistor of claim 13.

16. A thin film transistor of claim 13, wherein the existing primary crystal grain boundaries have an inclined angle from 45 to 135° with respect to a current flow direction.
